# EUROPEAN PATENT SPECIFICATION

(11) **EP 4 576 191 B1**
(45) Date of publication and mention of the grant of the patent: **12.08.2026**
(21) Application number: 23220073.3
(22) Date of filing: 22.12.2023
(51) Int. Cl.: H10D 30/01, H10D 64/01, H10D 84/01, H10D 84/03, H10D 88/00, H10D 84/83, H10D 30/43, H10D 62/10, H10D 62/17, H10P 14/60, H10P 14/692

(54) **A METHOD FOR FORMING A SEMICONDUCTOR STRUCTURE**
VERFAHREN ZUR HERSTELLUNG EINES HALBLEITERMUSTERS
PROCÉDÉ DE FORMATION D'UNE STRUCTURE SEMI-CONDUCTRICE

(43) Date of publication of application: 25.06.2025
(73) Proprietor: IMEC VZW, 3001 Leuven (BE); Tokyo Electron Limited, Tokyo 107-6325 (JP)
(72) Inventor: CHAN, Boon Teik, 3012 Wilselse (BE); DEMUYNCK, Steven, 3200 Aarschot (BE); ALTAMIRANO SANCHEZ, Efrain, 3010 Kessel-Lo (BE); SEPULVEDA MARQUEZ, Alfonso, 3000 Leuven (BE); ISHIDA, Masafumi, Nirasaki-city 407-0192 (JP)
(74) Representative: AWA Sweden AB

(56) References cited:
- US-A1- 2017 018 452
- US-A1- 2021 265 348
- US-A1- 2022 235 456
- US-A1- 2023 086 633
- US-A1- 2023 307 456

## Description

### TECHNICAL FIELD

The present disclosure relates to a method for forming a semiconductor structure.

### BACKGROUND

Complementary FETs (CFETs) are currently on the scaling roadmap as one of the next generation scaling options. The CFET comprises a NFET (i.e. a N-type FET) and a PFETR (i.e. a P-type FET) stacked on top of each other (or the reverse). The NFET and the PFET are separated vertically by a middle dielectric isolation (MDI) and the bottom device can also be isolated from the substrate by a bottom dielectric isolation (BDI).

US 2023/0086633 A1 discloses a method of forming a stack of transistors comprising inner spacers and MDI and BDI layers, which may be formed by chemical vapor deposition (CVD). US 2023/0307456 A1 discloses a method of forming a stack of transistors comprising inner spacers and an MDI layer, which may be deposited by CVD. US 2017/0018452 A1 discloses forming a shallow trench isolation on a wafer by using a CVD process similar to the one used in the present invention.

### SUMMARY

It is an objective of the present inventive concept to provide an improved production method for a semiconductor structure.

A further objective is to provide a method for forming a semiconductor structure having comparably less processing steps.

A further objective of the method according to the invention is to provide a stable semiconductor structure with improved electrical performance. Further and alternative objectives may be understood from the following.

The invention is defined by the appended claims.

According to a first aspect of the invention, there is provided a method for forming a semiconductor structure, the method comprising:
forming a layer stack on a substrate, the layer stack comprising:
   a first sub-stack comprising a first sacrificial layer and on the first sacrificial layer a channel layer defining a topmost layer of the first sub-stack,
   a second sub-stack on the first sub-stack and comprising a plurality of sacrificial layers alternating between first and second sacrificial layers, wherein neighboring first and second sacrificial layers of the second sub-stack are separated by a liner layer, wherein first sacrificial layers define a respective bottommost and topmost layer of the second sub-stack, the second sub-stack comprising at least one second sacrificial layer;
   a third sub-stack on the second sub-stack and comprising a channel layer defining a bottommost layer of the third sub-stack and a first sacrificial layer on the channel layer;
   wherein the first sacrificial layers are formed of a first sacrificial semiconductor material, the second sacrificial layers are formed of a second sacrificial semiconductor material different from the first sacrificial semiconductor material, and the liner layers are formed of a semiconductor material different from the first and second semiconductor materials;
forming source/drain recesses, the source/drain recesses exposing end surfaces of the layer stack;
forming recesses in the first sacrificial layers of the layer stack by laterally etching back the end surfaces of the first sacrificial layers from opposite ends of the layer stack, by selective etching;
   removing the at least one second sacrificial layer of the second sub-stack by selective etching, thereby forming at least one cavity, while the first sacrificial layers of the second sub-stack are being protected from vertical etching by the liner layers; and
depositing dielectric material in the at least one cavity; and
depositing dielectric material in the recesses of the first sacrificial layers;
wherein at least one of said acts of depositing dielectric material in the at least one cavity; and depositing dielectric material in the recesses of the first sacrificial layers, is performed by a first chemical vapor deposition method, CVD method, the first CVD method comprising:
   reacting, as a film-forming gas, an oxygen-containing silicon compound gas with a non-oxidizing hydrogen-containing gas in a state in which at least the non-oxidizing hydrogen-containing gas is plasmarized, to form a film of a flowable silanol compound; and
   subsequently, annealing the film of flowable silanol compound into the first dielectric material,
   wherein the oxygen-containing silicon compound gas comprises SiₐO_{β}(O-CₘHₙ)_{Γ}CₓH_{y}, wherein m, n, and α are integers of 1 or more; and wherein β, Γ, x, and y are integers of 0 or more; and β and Γ are not 0 at the same time.

By the wording "a first layer arranged on a second layer" in reference to any of the layers (or layers of the sub-stack) of the layer stack is hereby meant that the first layer is arranged directly on (i.e. in abutment with) the second layer.

Relative spatial terms such as "topmost", "bottom", "lower", "vertical", "stacked on top of", are herein to be understood as denoting locations or directions within a frame of reference of the semiconductor structure. In particular, the terms may be understood in relation to a normal direction to the substrate on which the layer stack is formed, or equivalently in relation to a bottom-up direction of the layer stack. Correspondingly, terms such as "lateral" and "horizontal" are to be understood as locations or directions parallel to the substrate.

The term "thickness" is to be understood as a dimension of a structure (e.g. a layer of a sub-stack) as seen along a normal to a surface underlying the structure (e.g. the layer of the sub-stack). For example, the thickness of a layer of the layer stack, or the thickness of the sub-stack, may refer to the thickness dimension of the layer/sub-stack as seen along the bottom-up direction of the layer stack.

The semiconductor structure formed by the method of the invention is a semiconductor structure for producing a stack of field effect transistors (FETs) comprising a top and bottom FET. The stack of FETs may be CFET, wherein the top FET is a NFET and the bottom FET is a PFET, or vice versa. Thus, the semiconductor structure is a semiconductor structure suitable to be converted into a stack of FETs, e.g. a CFET.

Accordingly, the method is compatible with Complementary FET (CFET) device fabrication. The method is also compatible with forksheet device fabrication. The resulting semiconductor structure **is** used to produce a stack of FETs.

The layer stack may sometimes be referred to as a superlattice stack.

When this text refers to opposite ends of the layer stack, it can be understood that said opposite ends may be the end where source/drain regions are to be formed.

Channel layers of the first sub-stack may be channel layers for a bottom FET. Similarly, channel layers of the third sub-stack may be channel layers for a top FET. Channel layers may be Si layers.

First sacrificial layers may be layers that can be replaced with a gate stack during production of a stack of FETs.

Second sacrificial layers are layers that are replaced with dielectric material during production of a stack of FETs. The dielectric material may then function as electrical isolation between the bottom and top FET. Such electrical isolation between the bottom and top FET may be referred to as middle dielectric isolation.

The liner layers are layers resistant to the etchant used to etch the second sacrificial layers. The liner layers may be layers resistant to the etchant used to recess the first sacrificial layers. The liner layers may be thin, e.g. thinner than the first and second sacrificial layers.

As mentioned, the first and second sacrificial layers are formed of different semiconductor materials. Thus, etchants may have different etch rates for the first and second sacrificial layers. Thus, the first and second sacrificial layers may be selectively etched at different points in the production process, or should they be etched at the same time, they will be etched a different amount. The channel layers, liner layers, first sacrificial layers and second sacrificial layers may all be of different materials. Alternatively, channel layers and liner layers are formed of the same material, different from the first and second sacrificial semiconductor materials. Advantageously, channel layers and liner layers are formed of Si and first and second sacrificial layers are formed of SiGe, wherein first and second sacrificial layers have different Ge composition.

The dielectric material that is deposited in the at least one cavity may form a respective layer of MDI.

The dielectric material may be a nitride such as SiN. The dielectric material may be conformally deposited (e.g. by ALD) with a thickness sufficient to fill (and pinch-off) the respective cavity. Examples of a dielectric material include SiO2, Si3N4, SiCO, SiOCN, SiON, SiCN, SiC, SiBCN, and SiBCNO.

The dielectric material that is deposited in the recesses of the first sacrificial layers may form inner spacers.

By the term "inner spacers" is hereby meant dielectric layer portions formed in the recesses to cover end surfaces of the first sacrificial layers. Forming the inner spacers may comprise conformally depositing an inner spacer material layer. Forming the inner spacers may comprise subsequently etching the inner spacer material layer such that a discrete portion of the inner spacer material layer remain in each recess to form an inner spacer therein. The spacer material may in particular be etched using an isotropic etching process. An isotropic etching process allows the inner spacer material layer to be etched at a uniform rate (at least substantially). Hence, the structures covered by the inner spacer material layer may remain covered from the etchants by the inner spacer material layer substantially until the channel layer end surfaces are exposed, wherein the etching may be stopped. The inner spacer material layer may be deposited with a thickness such that the recesses are pinched-off (i.e. closed).

By the term "conformally depositing" is hereby meant a deposition process resulting in a conformally growing layer or film. Conformal deposition may be achieved using an atomic layer deposition (ALD) process.

According to the invention, at least one of the deposition steps of the dielectric material defined in claim 1, such as forming dielectric layers and inner spacers, is formed with the first CVD method. Any advantages of using the first CVD method compared to using conventional methods such ALD will be apparent from the following.

The first CVD process is described in US20220235456A1, which is hereby incorporated by reference. In particular, the detailed description of US20220235456A1 is incorporated by reference.

The first CVD method may be called Ultra Chemical Vapor Deposition (UCVD) or Chemical Vapor Liquid Deposition. In the following description the term UCVD will primarily be used.

The UCVD method enables a number of advantages:
The UCVD method may primarily deposit material in cavities and/or trenches. Thus, the dielectric material is primarily deposited in the cavity formed by removing the second sacrificial layer and/or in the recesses. The dielectric material deposited by the UCVD method may have a flat profile.

It may in this context be noted that by flat profiles it is generally meant that end surfaces of the dielectric material may have little or no rounding. The rounding of corners of the end surfaces may sometimes be referred to as curving. The provision of such flat profile dielectric material may enable a reduction of processing steps since separate steps such as pre-cleaning may not be needed. The reduction of pre-cleaning steps may enable a reduction of erosion of the dielectric layers/sacrificial layer, or any other layers of the layer stack that would normally be subjected to erosion.

Further, the UCVD method may provide dielectric material compound with few voids, e.g. void free dielectric material, and thereby there may be provided high quality dielectric material.

The formation of the recesses in the first sacrificial layers and the removal of the at least one second sacrificial layer is performed by etching. The liner layers are particularly important as they protect the interface between first and second sacrificial layers during said etch. Thus, the liner layer is a layer resistant to the etchant used to etch the second sacrificial layers. The liner layers may be thin, e.g. thinner than the first and second sacrificial layers. Thus, the liner layers may protect the interface between first and second sacrificial layers while at the same time contributing little or not at all to the strain in the layer stack.

It may in this context by noted that the liner layers may protect the interface between the first and second sacrificial layers in that sense that any erosion of the first and second sacrificial layers may be prevented, or at least reduced. Such an erosion could normally result in undesirable profiles, e.g. curving of end surfaces, of the first and second sacrificial layers which in turn would hamper the ability to form high-quality dielectric layers in the layer stack. The provision of liner layers may thus facilitate the formation of high-quality dielectric layers which in turn results in a semiconductor structure with improved electrical performance.

It may in this context be further noted that the liner layers do not necessarily only provide protection for the first and second sacrificial layers. The liner layers may provide protection and thereby reduce erosion of the remaining layers of the layer stack, such as the channel layers.

Also, the employment of liner layers in combination with deposition performed by the UVCD method may together contribute to even higher quality dielectric layers.

Although the method may advantageously be used in conjunction with forming forksheet and CFET devices, it is contemplated that the method may be used also to form other horizontal channel FET devices (e.g. nanowire FETs (NWFETs) or as discussed above, nanosheet FETs (NSHFETs)) requiring inner spacers, and which may benefit from liner layers.

By the term "layer stack" is hereby meant a structure of layers, sequentially formed on top of each other. The layer stack may in particular be fin-shaped.

Said act of depositing dielectric material in the at least one cavity may be performed by the first CVD method.

By depositing dielectric material in the at least one cavity by the first CVD method, deposition of dielectric material elsewhere may be reduced or avoided altogether. Thus, cleaning steps may be reduced during production.

By depositing dielectric material in the at least one cavity by the first CVD method, a MDI with little or no curving profile may be achieved. Thus, the ends of the MDI may be flat.

Both acts of depositing dielectric material in the at least one cavity; and depositing dielectric material in the recesses of the first sacrificial layers, may be performed by the first chemical vapor deposition method.

Thus, cleaning steps may be further reduced during production. A MDI and inner spacers with little or no curving profile may be achieved. Thus, the ends of both of the MDI and the inner spacers may be flat.

The acts of depositing dielectric material in the at least one cavity; and depositing dielectric material in the recesses of the first sacrificial layers, may be performed simultaneously.

By depositing dielectric material in the at least one cavity and in the recesses simultaneously the manufacturing process may be simplified.

It may in this context be noted that the act of depositing dielectric material in the at least one cavity and in the recesses simultaneously implies that the dielectric material in the at least one cavities and the recesses may be of the same material.

A material of the channel layers may be Si₁₋ₐGeₐ, a material of the liner layers may be Si_{1-b}Ge_{b}, the first sacrificial semiconductor material may be Si_{1-c}Ge_{c}, and the second sacrificial semiconductor material may be Si_{1-d}Ge_{d}, wherein 0 ≤ a ≤ b < c < d.

The channel layer may be formed of a channel material being Si₁₋ₐGeₐ. The channel material may be Si. As such, a may be equal to 0.

The liner layer may be formed of a liner layer material being Si_{1-b}Ge_{b}. The layer material may be Si. As such, b may be equal to 0.

The first sacrificial layer may be formed of a first sacrificial material being Si_{1-c}Ge_{c}.

The second sacrificial layer may be formed of a second sacrificial material being Si_{1-d}Ge_{d}.

The first and second sacrificial materials may be chosen such that d is greater than c. In other words, the Ge-content of the second sacrificial material may be greater than that of the first sacrificial material. The first sacrificial layer may thus be said to be formed of a first sacrificial material having low Ge-content. In other words, layers adjacent to the channel layers may have low Ge-content. The second sacrificial layer may thus be said to be formed of a second material having high Ge-content. The second sub-stack may hence comprise a plurality of sacrificial layers alternating between having high and low Ge-content.

The first sacrificial semiconductor material may have such a composition that c is in a range of 0.1-0.25. The second sacrificial semiconductor material may have such a composition that d is in a range of 0.35-0.5.

By way of example, the first sacrificial material may be Si_{0.75}Ge_{0.25}, and the second sacrificial material may be Si_{0.5}Ge_{0.5}. Such relative differences in Ge-content may facilitate a selective processing (e.g. selective etching) of the different sacrificial layers, the liner layers, and the channel layers of the layer stack.

A material of the liner layers may have such a composition that b is below 0.05.

By way of example, the liner layer material may be Si_{0.98}Ge_{0.02}. Thus, the Ge-content of the liner layers may be sufficiently different from the Ge-contents of the sacrificial layers. Such relative differences in Ge-content may facilitate a selective processing (e.g. selective etching) of the different sacrificial layers and the channel layers of the layer stack, while enabling little or no erosion of the liner layers.

The dielectric material deposited by the first CVD method may comprise SiOC or SiOCN.

Such materials may provide sufficient electrical isolation between the channel(s) of the first sub-stack and channel(s) the third sub-stack.

Said act of forming recesses in the first sacrificial layers of the layer stack:
may be performed before said act of removing the at least one second sacrificial layer of the second sub-stack; and
may be performed using a first selective etch being selective to material of the channel layers and material of the liner layers but not to the first and second sacrificial semiconductor material.

Thus, the channel layers and the liner layers may remain in the layer stack while the first and second sacrificial layers may be etched. The channel layers and the liner layers may be subjected to little or no erosion.

Said act of removing the at least one second sacrificial layer of the second sub-stack may be performed using a second selective etch being selective to material of the channel layers, material of the liner layers, and the first sacrificial semiconductor material but not to the second sacrificial semiconductor material.

Thus, the channel layers, the liner layers, and the first sacrificial layers may remain in the layer stack while the second sacrificial layers may be etched. The channel layers, the liner layers, and the first sacrificial layers may be subjected to little or no erosion.

A thickness of the liner layers may be in a range of 1 nm to 5 nm.

By way of example, a thickness of the liner layers may be 1 nm, 2 nm, 3 nm, 4 nm, or 5 nm. By way of another example, a thickness of the liner layers may be below 2 nm, 3 nm, 4 nm, or below 5 nm. Such a thickness of the liner layers provides sufficient protection for the first sacrificial layers of the second sub-stack when removing the second sacrificial layers, while simultaneously providing a semiconductor structure being thin. This enables further device scaling. Also, a reduced growth thickness of the liner layers may enable a reduced amount of growth defects of the layer stack. The liner layers may be thin enough to prevent parasitic source and drain epitaxial growth.

Further, such a liner thickness may prevent diffusion of atoms throughout the layer stack during processing steps such as anneal, while still enabling a comparably thin semiconductor structure.

The recesses may comprise isotropic selective etching of the end surfaces of the first sacrificial layers from opposite ends of the layer stack.

Due to the liner layers, rounding of corners of the first sacrificial layers may be avoided, even if the etching of end surfaces of the first sacrificial layers is done isotropically. In other words, the employment of liner layers enables isotropic selective etching while avoiding rounding of corners of the first sacrificial layers. Isotropic etching of the end surfaces allows for a controlled formation of the recesses. As such, this facilitates subsequent processing steps e.g. the act of depositing dielectric material in the cavities/recesses.

The method may further comprise:
forming a sacrificial gate structure extending across the layer stack, the sacrificial gate structure comprising a sacrificial gate body and a first spacer on opposite sides of the sacrificial gate body;
wherein the source/drain recesses are formed by
etching through the device layer stack while using the sacrificial gate structure as an etch mask such that portions of the first, second and third sub-stacks of the layer stack are preserved underneath the sacrificial gate structure.

The method may accordingly provide an efficient manufacturing of the semiconductor structure.

The method may further comprise:
forming source and drain regions by epitaxially growing semiconductor material on channel layer end surfaces exposed in the source/drain recesses.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
Figs. 1 to 12 illustrate the semiconductor structure formation steps of a method applied to a semiconductor device in a schematically depicted cross-sectional view, according to some embodiments.
Figs. 13 to 16 illustrate the semiconductor structure formation steps of a method applied to a semiconductor device in a schematically depicted cross-sectional view, according to some embodiments.

### DETAILED DESCRIPTION

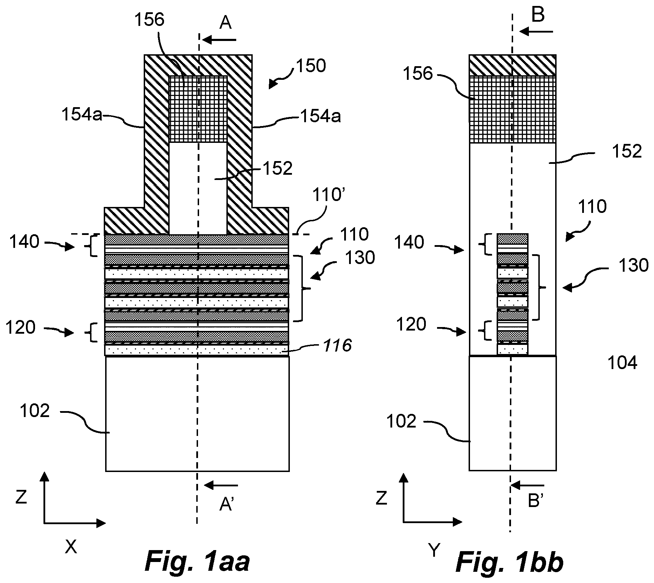

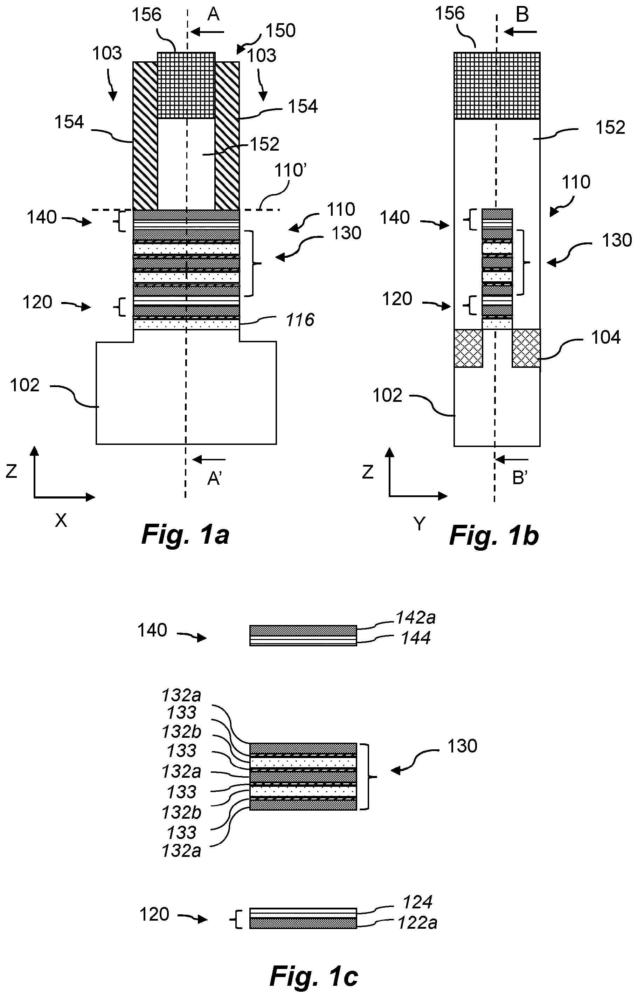

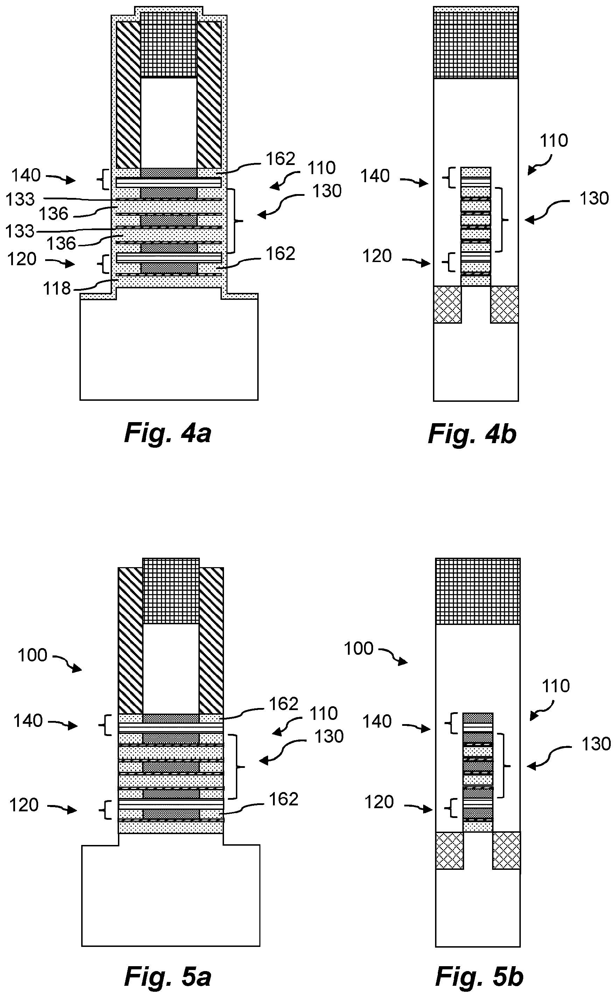

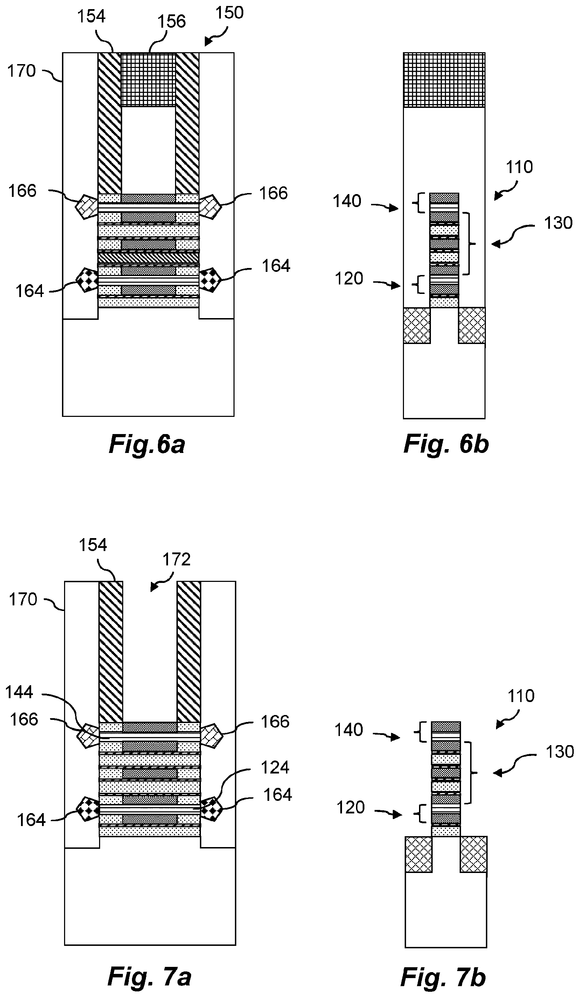

Figs. 1 to 5 illustrate one implementation of the method according to the invention. This implementation may be called implementation A. Figs. 1aa-bb depict a layer stack 110 at an initial stage of a method for forming a resulting semiconductor structure 100. Figs. 1 to 5 illustrate the formation of a semiconductor structure 100, wherein the finished semiconductor structure 100 is shown in Figs. 5a-b. Figs. 6a-b to 12a-b then shows the formation of a stack of FETs 1000 starting from said semiconductor structure 100. The stack of FETs 1000 may be a CFET device.

Axes X, Y and Z indicate a first direction, a second direction transverse to the first direction, and a vertical or bottom-up direction, respectively. The X- and Y-direction may in particular be referred to as lateral or horizontal directions in that they are parallel to a main plane of a substrate 102 of the structure 100. The Z-direction is parallel to a normal direction to the substrate 102.

Figs. 1aa-bb depict respective cross-sectional views of the layer stack 110 taken along vertical planes B-B' (parallel to the XZ-plane) and A-A' (parallel to the YZ plane). The cross-sectional views of the subsequent figures correspond to those in Figs. 1aa-bb unless stated otherwise.

The layer stack 110 is arranged on a substrate 102. The substrate 102 may be a conventional semiconductor substrate suitable for complementary FETs. The substrate 102 may be a single-layered semiconductor substrate, for instance formed by a bulk substrate such as a Si substrate, a germanium (Ge) substrate or a silicon-germanium (SiGe) substrate. A multi-layered / composite substrate is however also possible, such as an epitaxially grown semiconductor layer on a bulk substrate, or a semiconductor-on-insulator (SOI) substrate, such as a Si-on-insulator substrate, a Ge-on-insulator substrate, or a SiGe-on-insulator substrate.

The device layer stack 110 comprises a first sub-stack 120, a second sub-stack 130 on the first sub-stack 120, and a third sub-stack 140 on the second sub-stack 130.

Fig. 1c depicts the first sub-stack 120 (bottom), the second sub-stack 130 (middle) and the third sub-stack 140 (top) in isolation for illustrational clarity.

The first sub-stack 120 comprises a first sacrificial 122a and a channel layer 124 on the first sacrificial layer 122a. The channel layer 124 forms a top (i.e. topmost) layer of the first sub-stack 120. The layers 122a and 124 may be referred to as one unit of the first sub-stack 120. Although Fig. 1c depicts merely one such unit (i.e. a single) of the first sub-stack 120, it is to be understood that the first sub-stack 120 may comprise more than merely a single unit. For instance, the first sub-stack 120 may e.g. comprise two, three, or four etc. units. As such, the first sub-stack 120 may comprise two, three, or four etc. first sacrificial layers 122a and channel layers 124, respectively. In case the first sub-stack 120 comprises a plurality of such units, said units may be consecutively arranged. For instance, the units may be arranged on top of each other.

The second sub-stack 130 comprises a plurality of sacrificial layers alternating between first and second sacrificial layers 132a, 132b. Neighboring first and second sacrificial layers 132a, 132b of the second sub-stack 130 are separated by a liner layer 133. It may thus be said that the liner layer 133 may abut each first and second sacrificial layer 132a, 132b that it separates.

Fig. 1c illustrates a second sub-stack 130 comprising (along a bottom-up direction) a bottommost first sacrificial layer 132a, a liner layer 133, a second sacrificial layer 132b, a liner layer 133, a first sacrificial layer 132a, a liner layer 133, a second sacrificial layer 132b, a liner layer 133, and a topmost first sacrificial layer 132a. The bottommost first sacrificial layer 132 is thus arranged on the first sub-stack 120, i.e. on the topmost channel layer 124. Although Fig. 1c depicts merely two second sacrificial layers 132b of the second sub-stack 130, it is to be understood that the second sub-stack 130 may comprise more than merely two second sacrificial layers 132b. It is also conceivable that the second sub-stack 130 may comprise one (i.e. a single) second sacrificial layer 132b.

The third sub-stack 140 comprises a channel layer 144 and a first sacrificial layer 142a on the channel layer 144. The channel layer 144 forms a bottom (i.e. bottom-most) layer of the third sub-stack 140. The channel layer 144 is thus arranged on the second sub-stack 130, i.e. on the topmost first sacrificial layer 132a. The layers 144 and 142a may be referred to as one unit of the third sub-stack 140. Although Fig. 1c depicts merely one such unit (i.e. a single) of the third sub-stack 140, it is to be understood that the third sub-stack 140 may comprise more than merely a single unit. For instance, the third sub-stack 140 may e.g. comprise two, three, or four etc. units. As such, the third sub-stack 140 may comprise two, three, or four etc. first sacrificial layers 142a and channel layers 144, respectively. In case the third sub-stack 140 comprises a plurality of such units, said units may be consecutively arranged. For instance, the units may be arranged on top of each other.

The first sacrificial layers of the first through third sub-stacks 120, 130, 140 (122a, 132a, 142a) and the second sacrificial layers of the first through third sub-stacks 120, 130, 140 may be formed with a uniform or at least similar thickness. It is also conceivable that the second sacrificial layers may be formed with a greater thickness than each of the first sacrificial layers of the first through third sub-stacks 120, 130, 140 (122a, 132a, 142a). The total thickness of the second sub-stack 130 may accordingly exceed a thickness of each first sacrificial layer of the first sub-stack 120 and the third sub-stack 140.

The channel layers of the first and third sub-stacks 120, 140 may also be of a uniform or at least similar thickness, e.g. a different or a same thickness as the first sacrificial layers of the layer stack 110.

Each of the liner layers of the second sub-stack 130 may be of a uniform or at least similar thickness.

By way of example, the channel layers of the first and third sub-stacks 120, 140 may each be formed with a thickness of 3-10 nm, the first sacrificial layers of the first through third sub-stacks 120, 130, 140 (122a, 132a, 142a) may each be formed with a thickness of 3-10 nm, the second sacrificial layers 132b may be formed with a thickness of 5-30 nm, and the liner layers 133 may be formed with a thickness of 1-5 nm. The liner layers 133 are preferably 2-3 nm. The total thickness of the second sub-stack 130 may for example be 20-50 nm.

Each first sacrificial layer of the first through third sub-stacks 120, 130, 140 (122a, 132a, 142a) is formed of a same first sacrificial material.

The second sacrificial layer(s) 132b of the second sub-stack 130 is formed of a second sacrificial material different from the first sacrificial material. Each channel layer of the first and third sub-stacks 120, 140 (124, 144) is formed of a same channel material, different from each of the first and second sacrificial materials. The liner layers 133 are formed of a semiconductor material different from the first and second semiconductor materials.

For example, the channel material may be Si₁₋ₐGeₐ, the liner material may be Si_{1-b}Ge_{b}, the first sacrificial material may be Si_{1-c}Ge_{c}, and the second sacrificial material may be Si_{1-d}Ge_{d}, wherein 0 ≤ a ≤ b < c < d. For example, c may be in a range of 0.1-0.25. Further, d may be in a range of 0.35-0.5. In a more specific example, the channel material may be Si (i.e. a = 0), the liner material may be Si (i.e. b = 0), the first sacrificial material may be Si_{0.75}Ge_{0.25}, and the second sacrificial material may be Si_{0.5}Ge_{0.5}. These relative differences in Ge-content facilitate a selective processing (e.g. selective etching) of the different sacrificial layers, the liner layers 133, and the channel layers of the layer stack 110.

The layers of the device layer stack 110 may each be epitaxial layers, e.g. epitaxially grown using deposition techniques which per se are known, such as chemical vapor deposition (CVD) or physical vapor deposition (PVD). This enables high quality material layers with an advantageous degree of control of composition and dimensions.

The deposited layers may be sequentially formed and subsequently patterned to define an elongated fin-shaped layer stack, extending in the X-direction. The dashed line 110' schematically indicates a contour of the layer stack 110 subsequent to fin patterning and prior to fin recess, described below. While the figures depict only a single layer stack, it is to be understood that a plurality of parallel fin-shaped layer stacks may be formed. Conventional fin patterning techniques may be used, e.g. single patterning techniques such as lithography and etching ("litho-etch") or multiple-patterning techniques such as (litho-etch)x, self-aligned double or quadruple patterning (SADP or SAQP).

The layers of the layer stack 110 may each be formed as nanosheets, e.g. with a width (along Y) to thickness (along Z) ratio greater than 1, such as a width in a range from 10 nm to 30 nm and a thickness in a range from 3 nm to 10 nm. It is also possible to pattern the layer stacks such that the channel layers form nanowire-shaped layers. A nanowire may by way of example have a thickness similar to the example nanosheet however with a smaller width, such as 3 nm to 10 nm.

As shown in Figs. 1a-b, subsequent to the fin patterning, a lower portion of the device layer stack 110 may be surrounded by a shallow trench isolation (STI) 104, e.g. of SiO₂.

As further shown in Figs. 1aa-bb, a sacrificial gate structure 150 may be formed to extend across the layer stack 110. The sacrificial gate structure 150 comprises a sacrificial gate body 152 (and a gate spacer 154, discussed later). The sacrificial gate body 152 may be formed by depositing a sacrificial gate body material (e.g. amorphous Si) over the layer stack 110 and subsequently patterning the sacrificial gate body 152 therein. While the figures depict only a sacrificial gate structure 150, it is to be understood that a plurality of parallel sacrificial gate structures may be formed across the layer stack 110. Conventional patterning techniques may be used, e.g. single patterning techniques such as lithography and etching ("litho-etch") or multiple-patterning techniques such as (litho-etch)x, SADP or SAQP.

The sacrificial gate structure 150 is further conformally coated by a gate spacer material 154a. The gate spacer material 154a may be dielectric material, e.g. as an oxide, a nitride or a carbide such as SiN, SiC, SiCO, SiCN, SiOCN, SiON, or SiBCN deposited by ALD.

The sacrificial gate structure 150 may, as shown, further comprise a capping layer 156, e.g. formed of one or more layers of hardmask material remaining from the sacrificial gate body patterning.

Fig. 1a-b illustrate the formation of source/drain recesses 103.

After forming the sacrificial gate structure 150 the device layer stack 110 may be recessed by etching back the device layer stack 110 in a top down direction (e.g. negative Z) while using the sacrificial gate structure 150 as an etch mask. The etching may extend through each of the third, second and first sub-stacks 140, 130, 120 such that portions of each layer thereof are preserved underneath the sacrificial gate structure 150, as shown in Fig. 1a. As indicated in Fig. 1a-b, etching back the device layer stack 110 has formed recesses 103 in the layer stack 110. A respective recess 103 may be formed in the layer stack 110 at opposite sides of the layer stack 110. The recesses 103 may extend into the substrate 103.

After forming the source/drain recesses 103, portions of the gate spacer material 154a that remain on the end surfaces of the sacrificial gate body 152 define a first spacer or first spacer layer 154 on opposite sides of the sacrificial gate body 152. The first spacer 154 may also be referred to as gate spacer 154.

As will be apparent from the following, each of the first sacrificial layers of the first through third sub-stacks 120, 130, 140 (122a, 132a, 142a) will be subjected to the same process steps. Hence, for brevity, these layers will in the following be commonly denoted the first sacrificial layers of the device layer stack 110, or of the first sub-stack 120, the second sub-stack 130 or the third sub-stack 140. For corresponding reasons, the channel layers of the first and third sub-stacks 120, 140 (124, 144) may in the following be commonly denoted the channel layers of the layer stack 110, or of the first sub-stack 120 or the third sub-stack 140.

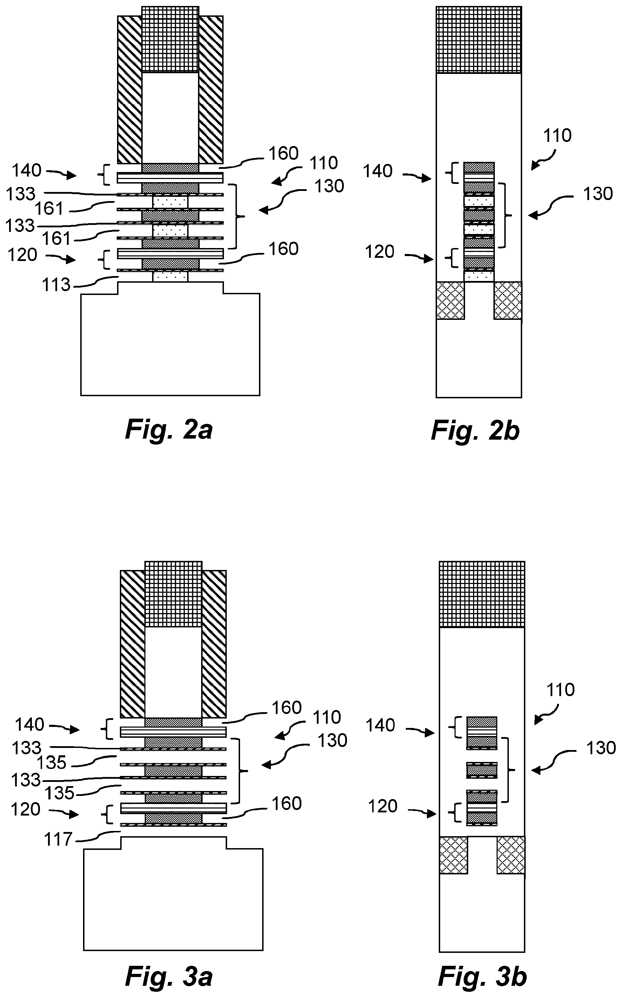

Fig. 2a-b show the formation of recesses 160 in the first sacrificial layers of the layer stack. The formation of recesses 160 may be formed subsequently to forming source/drain recesses 103.

In Fig. 2a, recesses 160 have been formed in the layer stack 110 by laterally etching back (e.g. along the X- and negative X-direction) end surfaces of each first sacrificial layer of the layer stack 110 from opposite ends of the layer stack 110, by selective etching. The lateral etch back may be achieved by an isotropic etching process. Any suitable dry etching process or wet etching process allowing selective etching of the first sacrificial material may be used (e.g. HCl, or APM). As indicated in Fig. 2a, the extent of the lateral etch back may correspond to a thickness of the gate spacer 154. In other words, a depth of the recesses 160 (e.g. along the X-direction) may correspond to the thickness of the gate spacer 154 (along the X-direction).

The act of forming the recesses 160 in the first sacrificial layers 122a, 132a, 142a may also be accompanied by the act of forming recesses 161 in the second sacrificial layers 132b. The formation of recesses 160 in the first sacrificial layers 122a, 132a, 142a may be performed simultaneous with the act of forming recesses 161 in the second sacrificial layers 132b. Alternatively, it is conceivable that recesses 161 may be formed in the second sacrificial layers 132b first. Recesses 160 may subsequently be formed in the first sacrificial layers.

As indicated in Fig. 2a, the extent of the lateral etch back of the second sacrificial layers 132b may correspond to a thickness greater than that of the gate spacer 154. In other words, a depth of the recesses 161 (e.g. along the X-direction) may be greater than the thickness of the gate spacer 154 and the recess 160 (along the X-direction). The first and second sacrificial layers may have different Ge-content and may thus be removed at a different rate depending on the etchant used. An etchant having a higher etch rate for material having a comparably high Ge-content may be used. Hence, it may be implied that the material of the second sacrificial layers 132b have a higher Ge-content.

As further seen in Fig. 2a, the liner layers 133 may prevent rounding of the corners of the first sacrificial layers 132a of the second sub-stack 130. Even if the second sacrificial layers 132b of the second sub-stack 130 may etch faster than the first sacrificial layers 132a of the second sub-stack 130, the etchant cannot attack the first sacrificial layers 132a via the recesses 161 in the second sacrificial layers 132b due to the protective liner layers 133. Thus, the first sacrificial layers 132a of the second sub-stack 130 may only be attacked laterally via the recesses 160 of the second sub-stack 130.

Figs. 3a-b show the removal of the second sacrificial layers of the second sub-stack.

In Fig. 3a the second sacrificial layers 132b of the second sub-stack 130 have been removed by selectively etching the second sacrificial semiconductor material, thereby forming a cavity 135 in the second sub-stack 130. The removal of the second sacrificial layers may occur prior to the deposition of dielectric material into any cavities or recesses. The second sacrificial semiconductor material may be etched using an isotropic etching process (wet or dry), to laterally etch back end surfaces of the second sacrificial layers 132b from opposite sides of the layer stack 110. For example, an HCl-based dry etch may be used to remove second sacrificial layer material having smaller Ge-content than that of the first sacrificial material. However, other appropriate etching processes (e.g. wet etching processes) are also known in the art and may also be employed for this purpose.

Figs. 4a-b show deposition of dielectric material in both the cavities 135 and the recesses 160.

In Figs. 4a-bthe cavities 135 and the recesses 160 have been filled with a dielectric material, e.g. such as SiOC or SiOCN. As such, the dielectric material in the cavities 135 and the recesses 160 may be the same. The dielectric material is herein deposited by UCVD, simultaneously in both the cavities 135 and the recesses 160. Examples of a dielectric material include SiOC or SiOCN.

As seen in Fig. 4a, the dielectric material deposited by UCVD may preferentially fill the cavities 135 and the recesses 160 and leave only a thin film of dielectric material, or no film, on the end surfaces of the layer stack. Thus, the end surfaces of the layer stack may, after deposition of the dielectric material be flat. If another deposition method had been used, the end surfaces of the layer stack may have been less flat. If another deposition method had been used, a surface of the dielectric material may be non-flat with protrusions over end surfaces of channel layers and liner layers, and/or indentations in the regions of the filled cavities 135 and recesses 160.

The first CVD method comprises:
reacting, as a film-forming gas, an oxygen-containing silicon compound gas with a non-oxidizing hydrogen-containing gas in a state in which at least the non-oxidizing hydrogen-containing gas is plasmarized, to form a film of a flowable silanol compound; and
subsequently, annealing the film of flowable silanol compound into the first dielectric material,
wherein the oxygen-containing silicon compound gas comprises SiₐO_{β}(O-CₘHₙ)_{┌}CₓH_{y}, wherein m, n, and α are integers of 1 or more; and wherein β, Γ, x, and y are integers of 0 or more; and β and Γ are not 0 at the same time.

The first CVD method may be called Ultra Chemical Vapor Deposition (UCVD) or Chemical Vapor Liquid Deposition. In the following description the term UCVD will primarily be used. The UCVD method may be advantageous over ALD, and other conventional methods, when filling the cavities 135 and recesses 160 with dielectric material. The advantages of using the UCVD method compared to conventional methods such as ALD have already been discussed and will for brevity not be elaborated any further.

The dielectric material has been subjected to an isotropic etching process to remove portions of the dielectric material deposited outside the respective cavity 135. Any suitable isotropic etching process (wet or dry) for etching the dielectric material (e.g. SiOC or SiOCN) may be used. The dielectric material remaining in the respective recess 160 forms the respective dielectric layer inner spacer 162. The dielectric material remaining in the respective cavity 135 forms the respective dielectric layer 136.

As discussed above, although Fig. 1c depicts two second sacrificial layers 132b of the second sub-stack 130, it is to be understood that the second sub-stack 130 may comprise more than merely two second sacrificial layers 132b. It is also conceivable that the second sub-stack 130 may comprise one (i.e. a single) second sacrificial layer 132b. Thus, subsequent processing steps may involve forming at least one dielectric layer 136.

Figs. 4a-b show end surfaces of channel layers being exposed.

As further shown in Fig. 5a, the inner spacers 162 and the dielectric layers 136 have been formed in the recesses 160 and the cavities 135, respectively, by subjecting the dielectric material to an isotropic etching process to remove portions of the dielectric material deposited outside the recesses 160 and the cavities 135. Any suitable isotropic etching process (wet or dry) for etching the dielectric material (e.g. SiOC or SiOCN) may be used. The etching may as shown be stopped when end surfaces of the channel layers of the layer stack 110 are exposed and discrete portions of the dielectric material remain in the recesses 160 and the cavities 135 to form the inner spacers 162 and the dielectric layers 136, respectively.

As shown in Fig. 1a, the layer stack 110 may also comprise a bottom second sacrificial layer 116. The bottom second sacrificial layer 116 may be arranged between the substrate 102 and the first sub-stack 120. A liner layer 133 may also be arranged between the bottom second sacrificial layer 116 and the first sub-stack 120. Said liner layer 133 may separate the bottom second sacrificial layer 116 from the first sub-stack 120. The liner layer 133 may abut the bottom second sacrificial layer 116 and the first sacrificial layer 122a of the first sub-stack 120.

The bottom second sacrificial layer 116 may be subject to the same processing steps as the second sacrificial layers 132b of the second sub-stack 130 (and the first sacrificial layers of the sub-stacks 120, 130, 140). Hence, for brevity, said processing steps will not be elaborated in detail.

In Figs. 2a to 3a-b, the bottom second sacrificial layer 116 arranged between the substrate 102 and the bottom channel layer 112 has been removed by etching, thereby forming recesses 113 and subsequently a bottom cavity 117.

In Fig. 4a the bottom cavity 117 has been filled with a dielectric material. The dielectric material may be the same dielectric material that has filled the recesses 160 and the cavities 135.

The dielectric material has been subjected to an isotropic etching process to remove portions of the dielectric material deposited outside the bottom cavity 117. Any suitable isotropic etching process (wet or dry) for etching the dielectric material (e.g. SiN) may be used. The dielectric material remaining in the bottom cavity 117 forms the dielectric layer 118.

In Figs. 6a-b, source and drain regions 164 and 166 have been formed on the channel layer(s) of the first sub-stack 120 and the third sub-stack 140, respectively. The source and drain regions 164, 166 have been formed by epitaxially growing semiconductor material on end surfaces of the channel layers exposed at opposite sides of the sacrificial gate structure 150. The source and drain regions 164, 166 may be formed by epitaxially growing semiconductor material on channel layer end surfaces exposed in the source/drain recesses 103.

The source and drain regions 164 formed on the channel layer end surfaces of the first sub-stack 120 may be of a first conductivity type and the source and drain regions 166 formed on the channel layer end surfaces of the third sub-stack 140 may be of a second opposite conductive type. The first and second conductivity types may be a p-type and an n-type, or vice versa. The doping may be achieved by in-situ doping. Different conductivity types of the source and drain regions 164 and the source and drain regions 166 may be achieved by masking the channel layer end surfaces of the third sub-stack 140 while performing epitaxy on the channel layer end surfaces of the first sub-stack 120. The masking of the channel layer end surfaces of the third sub-stack 140 may for example be provided by forming a temporary cover spacer along the third sub-stack 140. After completing the epitaxy of the source and drain regions 164, the temporary cover spacer may be removed and the source and drain regions 164 may be covered with one or more dielectric materials (e.g. ALD-deposited SiN and an inter-layer dielectric like SiO₂). Epitaxy may then be performed on the channel layer end surfaces of the third sub-stack 140. This is however merely one example and other process techniques facilitating forming of the source and drain regions 164, 166 with different conductivity types may also be used.

The source and drain regions 164, 166 may as shown subsequently be embedded in, or encapsulated by an insulating layer 170. The insulating layer 170 may be formed of an insulating material, such as an oxide, e.g. SiO₂, or another inter-layer dielectric, deposited, planarized and recessed, e.g. by chemical mechanical polishing (CMP) and/or etch back. The CMP and/or etch back may proceed to also remove any capping 156 of the sacrificial gate structure 150. It is however also possible to stop the CMP and/or etch back on the capping 156 and subsequently open the capping using a separate etch step.

In Figs. 7a-b a gate trench 172 has been formed by removing the sacrificial gate body 152 between the opposite gate spacers 154. Any conventional suitable etching process (isotropic or anisotropic, wet or dry) allowing selective removal of the sacrificial gate body 152 (e.g. of amorphous Si) may be used.

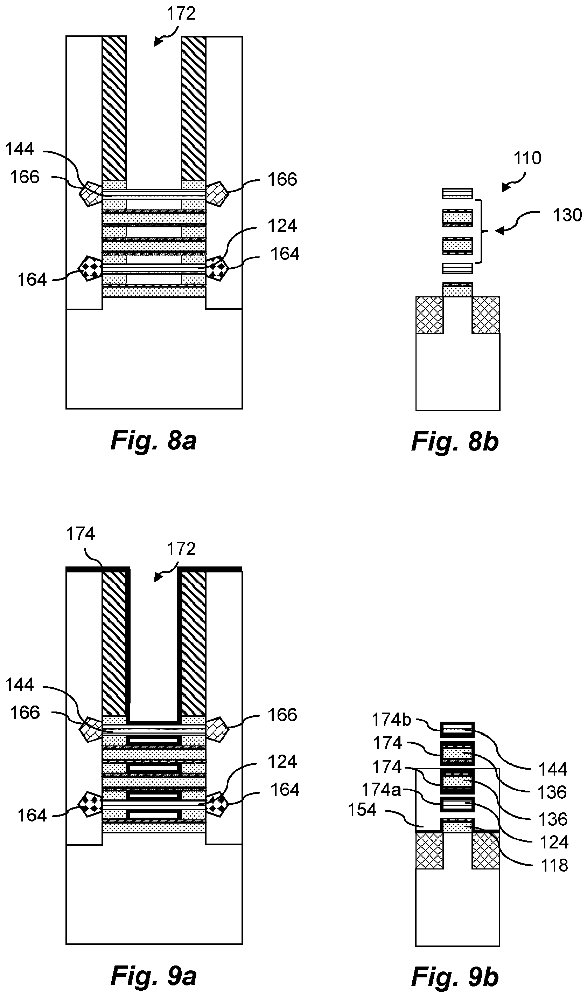

In Figs. 8a-b the first sacrificial layers of the device layer stack 110 have been removed by selectively etching the first sacrificial semiconductor material from the gate trench 172. A same type of etching process may be used for this step as during the forming of the recesses 160. By removing the first sacrificial layers, the channel layers of the device layer stack 110 may be released in the sense that upper and lower surfaces thereof may be exposed within the gate trench 172. Thus, second cavities 155 are formed. As the dielectric layer 154 prior to this process step was surrounded by first dielectric layers (e.g. the first dielectric layer 132a and the second dielectric layer 132b of the second sub-stack 130), also the dielectric layer 154 is released.

Figs. 9a-b to Figs. 12a-b illustrate process steps for forming a gate stack 180 surrounding the released channel layers and the dielectric layers 136 in the gate trench 172.

In Figs. 9a-b, a gate dielectric layer and then a first gate work function metal (WFM) 174 have been conformally deposited in the gate trench 172. The gate dielectric layer is for illustrational clarity not individually shown in the figures but its coverage may correspond with that indicated for layer 174. The gate dielectric layer may be formed of a conventional a high-k dielectric e.g. HfO2, HfSiO, LaO, AlO or ZrO. The first WFM 174 may be formed of one or more effective WFMs (e.g. an n-type WFM such as TiAl or TiAlC and/or a p-type WFM such as TiN or TaN). The gate dielectric layer and the first WFM may be deposited by ALD.

As further shown in Fig. 9b, a block mask 154 may subsequently be formed in a lower part of the gate trench 172. The block mask 154 may be formed a thickness (e.g. along the Z-direction) such that the portions of the first WFM 174 surrounding the channel layers of the first sub-stack 120 (e.g. portion 174a surrounding the channel layer 124) is covered and the portions of the first WFM 174 surrounding the channel layers 144 of the third sub-stack 140 (e.g. the portion 174b surrounding the channel layer 144) are exposed.

The block mask 154 may be formed by depositing a block mask material filling the gate trench 172. The block mask material may e.g. be spin-on-carbon or another organic spin-on material. The block mask material may subsequently be etched back top-down (e.g. using an anisotropic etch) to a target level. The target level may as shown be located between the dielectric layers 136. The portions of the first WFM 174 surrounding the channel layers of the third sub-stack 140 may thus be exposed.

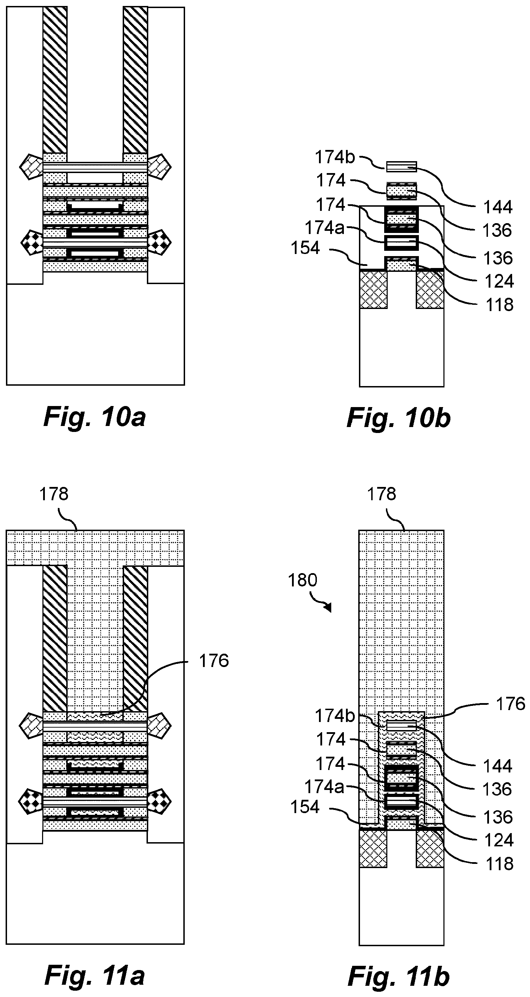

In Figs. 10a-b, the first WFM 174 has been removed from the channel layer(s) of the third sub-stack 140 while using the block mask 154 as an etch mask. Depending on the particular thickness of the block mask 154, at least a portion of the first WFM 174 surrounding the dielectric layers 136 may also be removed. The first WFM 174 surrounding the channel layer(s) to the first sub-stack 120 (e.g. the portion 174a surrounding the channel layer 124) may however be preserved, due to the block mask 154.

The first WFM 174 may be removed using a suitable isotropic (wet or dry) etch, allowing selective removal of the first WFM 174 without removing the gate dielectric. Subsequently, the block mask 154 may be removed from the trench 172.

In Figs. 11a-b, a second gate WFM 176 has been conformally deposited in the gate trench 172. The second WFM 176 may be deposited on the gate dielectric surrounding the channel layer(s) of the third sub-stack 140, and on portions of the gate dielectric exposed on the dielectric layers 136. The second WFM 176 may thus surround the channel layer(s) of the third sub-stack 140. As shown in Figs. 11a-b, the second gate WFM 176 may further be deposited on the first WFM 174 surrounding the channel layer(s) of the first sub-stack 140.

The first WFM 174 may form a first gate stack. The second gate WFM 176 may for a second gate stack. Each of the first and second gate stacks may extend through the second cavities 155.

Subsequently, a gate fill metal 178 (such as W) may be deposited to fill a remaining space of the gate trench 172. The gate fill metal 178 may for instance be deposited by CVD or PVD.

Reference sign 180 indicates the full gate stack, comprising a lower portion comprising the gate dielectric layer, the first WFM 174, the second WFM 176 and the gate fill metal 178 surrounding the channel layer(s) of the first sub-stack 110, and an upper portion comprising the gate dielectric, the second WFM 176 and the gate fill metal 178 surrounding the channel layer(s) of the third sub-stack 140.

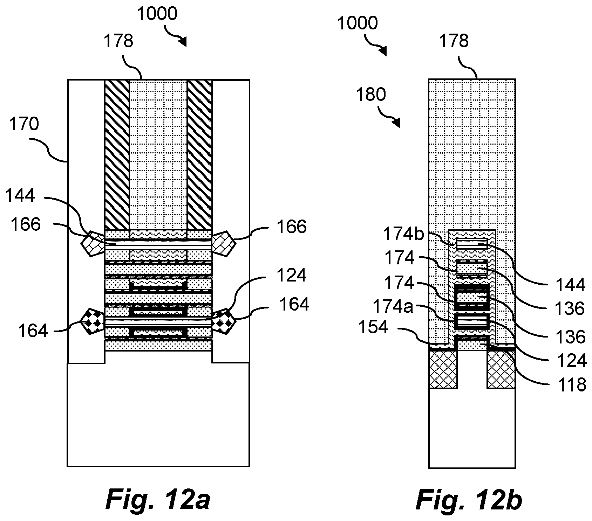

Figs. 12a-b depicts the resulting device structure 1000 subsequent to a gate metal recess to bring a top surface of the gate stack 180 flush with an upper surface of the gate spacers 154.

The device structure 1000 comprises a bottom device comprising the channel layer(s) of the first sub-stack 120, extending between the source and drain regions 164, and the lower portion of the gate stack 180. The device structure 1000 further comprises a bottom device comprising the channel layer(s) of the third sub-stack 140, extending between the source and drain regions 166, and the upper portion of the gate stack 180. The dielectric layers 136 remain as electrically inactive dummy channels, between the channel(s) of the bottom device and the top device and surrounded by the gate stack 180.

The method may thereafter proceed with forming source/drain contacts by etching contact trenches in the insulating layer 170 and depositing one or more contact metals in the trenches, on the source and drain regions 164, 166. Separate contacting of the source and drain regions of the bottom device and the top device may be achieved by a first contact metal deposition over the source and drain regions 164, 166, etch back of the contact metal to a level between the source and drain regions 164 and 166, thus exposing the source and drain regions 164, 166, deposition of an insulating contact separation layer on the etched back contact metal, and subsequently a second contact metal deposition over the source and drain regions 166. Separate source and drain contacting may be applied to either or both sides of the device 1000.

Alternative implementations of the method are also possible. For example, cavities may be formed and dielectric material deposited in said cavities before the source/drain recessing.

For example, cavities may be formed and dielectric material deposited in said cavities before the source/drain recess, the dielectric material deposited in said cavities being deposited by a method other than the first CVD method. We may call this implementation B.

As another example, cavities may be formed and dielectric material deposited in said cavities before the source/drain recess, the dielectric material deposited in said cavities being deposited by the first CVD method. We may call this implementation C.

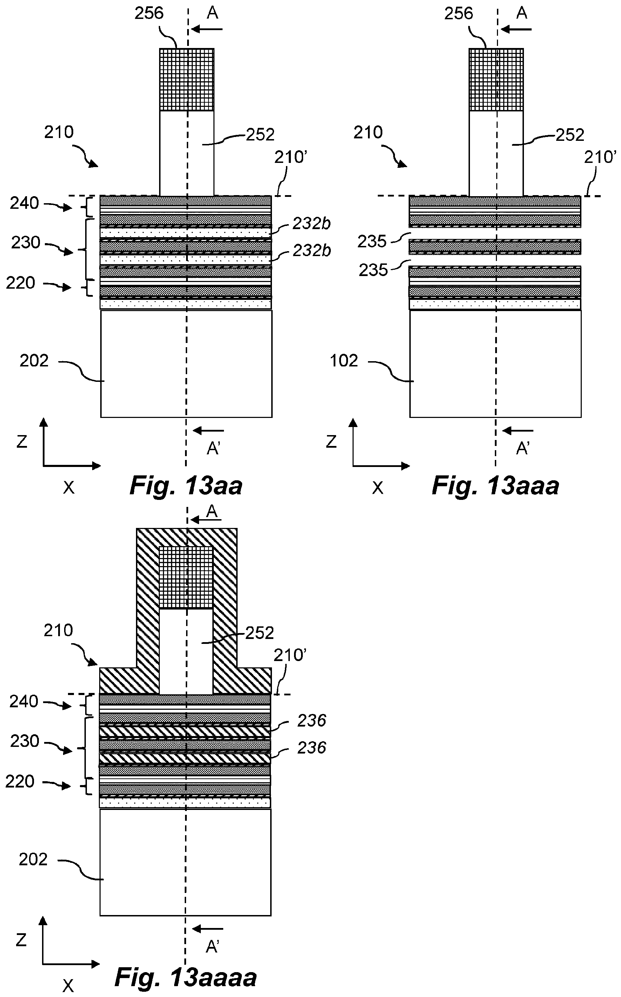

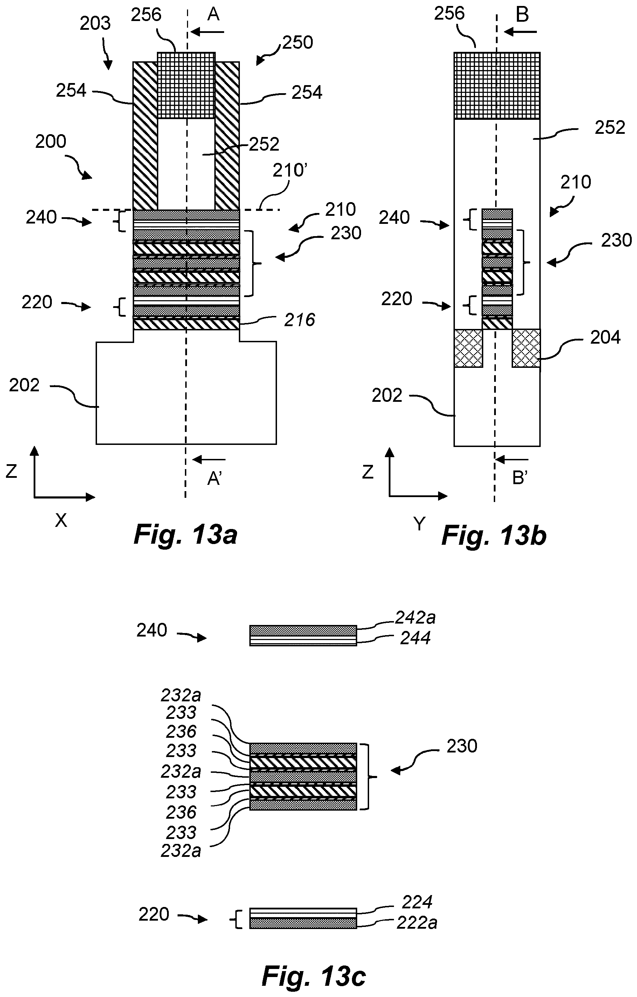

Figs. 13 to 15 illustrate implementation B.

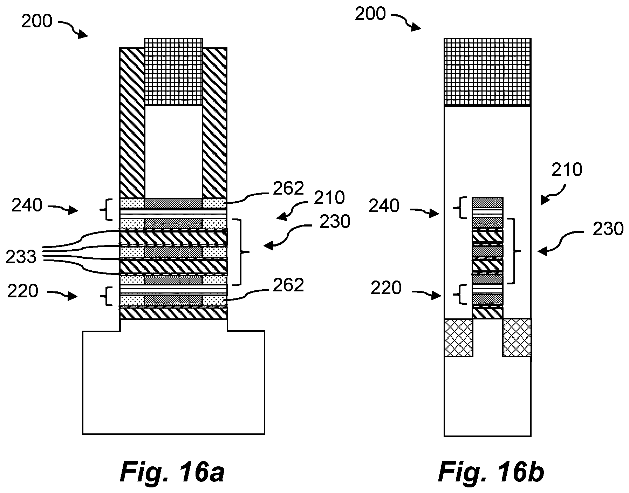

Figs. 13aa depict a layer stack 210 at an initial stage of a method for forming a resulting semiconductor structure 200. Figs. 13 to 15 illustrate the formation of a semiconductor structure 200, wherein the finished semiconductor structure 200 is shown in Figs. 16a-b.

The layer stack 210 is similar to the layer stack 110 but illustrated before being coated by gate spacer material 254a. As illustrated in Fig. 13aaa, the second sacrificial layers 232b may then be removed to form cavities 235.

Dielectric material may subsequently be deposited in the cavities 235 to form dielectric layers 236. Said dielectric layers 236 may be deposited by another method than the first CVD method. For example, said dielectric layers 236 may be of the same material as the gate spacer material 254a and deposited simultaneously with the gate spacer material 254a, as indicated in Fig. 13aaaa. Said dielectric layers 236 may be deposited by ALD, e.g. plasma enhanced ALD (PEALD). Said dielectric layers 236 may comprise Si₃N₄.

As seen in Fig. 13c, the first sub-stack 220 comprises a first sacrificial 222a and a channel layer 224 on the first sacrificial layer 222a. The channel layer 224 forms a top (i.e. topmost) layer of the first sub-stack 220.

The second sub-stack 230 comprises, subsequent to fin recess, a plurality of sacrificial layers and dielectric layers alternating between first sacrificial layers 232a and dielectric layers 236. Neighboring first and second sacrificial layers 232a, 232b of the second sub-stack 230 are separated by a liner layer 233. The liner layer 233 may abut each first and second sacrificial layer 232a, 232b that it separates. The bottommost first sacrificial layer 232a is thus arranged on the first sub-stack 220, i.e. on the topmost channel layer 224.

The third sub-stack 240 comprises a channel layer 244 and a first sacrificial layer 242a on the channel layer 244. The channel layer 244 forms a bottom (i.e. bottom-most) layer of the third sub-stack 240. The channel layer 244 is thus arranged on the second sub-stack 230, i.e. on the topmost first sacrificial layer 232a.

Fig. 13a-b illustrates the formation of source/drain recesses 203. This may be performed analogously with the description in conjunction with Fig. 1a-b.

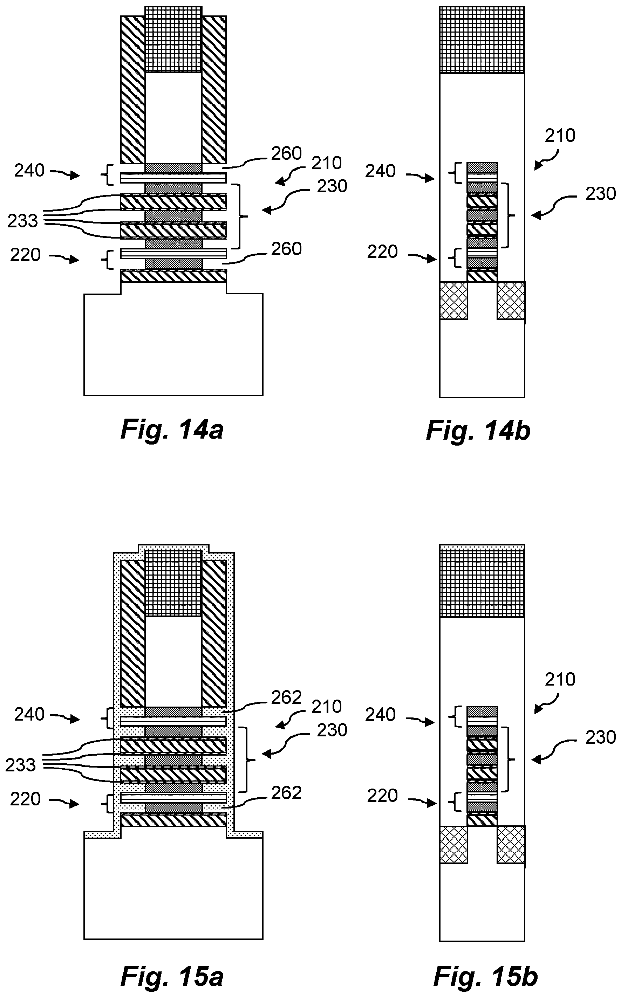

Fig. 14a-b show the formation of recesses 260 in the first sacrificial layers of the layer stack 210. This may be performed analogously with the description in conjunction with Fig. 2a-b with the exception that second sacrificial layers are not recessed. The reason being that second sacrificial layers have already been replaced with dielectric material.

Figs. 15a-b show deposition of dielectric material in the recesses 260 in the first sacrificial layers. This may be performed analogously with the description in conjunction with Fig. 4a-b, i.e. using the first CVD method. The exception being that dielectric material is not deposited in the cavities 235 since these are already filled.

Figs. 16a-b show end surfaces of channel layers being exposed. This may be performed analogously with the description in conjunction with Fig. 5a-b.

The rest of the processing for the S/D, gate trench and gate formation is analogous as described in conjunction with Figs. 7-12.

With regards to implementation C, wherein cavities are formed and dielectric material deposited in said cavities before the source/drain recess, the dielectric material deposited in said cavities being deposited by the first CVD method: In this implementation both acts of depositing dielectric material in the cavities; and depositing dielectric material in the recesses of the first sacrificial layers, are performed by the first CVD method, albeit at different points in time. The dielectric material deposited in the recesses of the first sacrificial layers may be either the same as or different from the dielectric material deposited in the cavities.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a semiconductor structure (100) comprising a stack of field effect transistors, FETs, the method comprising:
forming a layer stack (110; 210) on a substrate (102; 202), the layer stack (110; 210) comprising:
a first sub-stack (120; 220) comprising a first sacrificial layer (122a; 222a) and on the first sacrificial layer (122a; 222a) a channel layer (124; 224) defining a topmost layer of the first sub-stack (120; 220),
a second sub-stack (130; 230) on the first sub-stack (120; 220) and comprising a plurality of sacrificial layers alternating between first and second sacrificial layers (132a; 232a; 132b), wherein neighboring first and second sacrificial layers (132a; 232a; 132b) of the second sub-stack (130; 230) are separated by a liner layer (133; 233), wherein first sacrificial layers (132a; 232a) define a respective bottommost and topmost layer of the second sub-stack (130; 230), the second sub-stack comprising at least one second sacrificial layer (132b);
a third sub-stack (140; 240) on the second sub-stack (130; 230) and comprising a channel layer (144; 244) defining a bottommost layer of the third sub-stack (140; 240) and a first sacrificial layer (142a; 242a) on the channel layer (144; 244);
wherein the first sacrificial layers are formed of a first sacrificial semiconductor material, the second sacrificial layers are formed of a second sacrificial semiconductor material different from the first sacrificial semiconductor material, and the liner layers are formed of a semiconductor material different from the first and second semiconductor materials;
forming source/drain recesses (103), the source/drain recesses exposing end surfaces of the layer stack;
forming recesses (160; 260) in the first sacrificial layers of the layer stack by laterally etching back the end surfaces of the first sacrificial layers from opposite ends of the layer stack by selective etching;
removing the at least one second sacrificial layer of the second sub-stack by selective etching, thereby forming at least one cavity (135; 235), while the first sacrificial layers of the second sub-stack are being protected from vertical etching by the liner layers; and
depositing dielectric material in the at least one cavity; and
depositing dielectric material in the recesses of the first sacrificial layers;
wherein at least one of said acts of depositing dielectric material in the at least one cavity; and depositing dielectric material in the recesses of the first sacrificial layers, is performed by a first chemical vapor deposition method, CVD method,
**characterised in that**
the first CVD method comprises:
reacting, as a film-forming gas, an oxygen-containing silicon compound gas with a non-oxidizing hydrogen-containing gas in a state in which at least the non-oxidizing hydrogen-containing gas is plasmarized, to form a film of a flowable silanol compound; and
subsequently, annealing the film of flowable silanol compound into the first dielectric material,
wherein the oxygen-containing silicon compound gas comprises Si_{α}O_{β}(O-CₘHₙ)_{Γ}CₓH_{y}, wherein m, n, and α are integers of 1 or more; and wherein β, Γ, x, and y are integers of 0 or more; and β and Γ are not 0 at the same time.

2. The method according to claim 1, wherein said act of depositing dielectric material in the at least one cavity (135; 235) is performed by the first CVD method.

3. The method according to claim 1 or 2, wherein both acts of depositing dielectric material in the at least one cavity (135; 235); and depositing dielectric material in the recesses (160; 260) of the first sacrificial layers, are performed by the first chemical vapor deposition method.

4. The method according to claim 3, wherein the acts of depositing dielectric material in the at least one cavity (135); and depositing dielectric material in the recesses (160) of the first sacrificial layers, are performed simultaneously.

5. The method according to any one of the preceding claims, wherein a material of the channel layers is Si₁₋ₐGeₐ, a material of the liner layers is Si_{1-b}Ge_{b}, the first sacrificial semiconductor material is Si_{1-c}Ge_{c}, and the second sacrificial semiconductor material is Si_{1-d}Ge_{d}, wherein 0 ≤ a ≤ b < c < d.

6. The method according to claim 5, wherein c is in a range of 0.1-0.25, and d is in a range of 0.35-0.5.

7. The method according to claim 5 or claim 6, wherein b is below 0.05.

8. The method according to any one of the preceding claims, wherein the dielectric material deposited by the first CVD method comprises SiOC or SiOCN.

9. The method according to any one of the preceding claims, wherein said act of forming recesses (160) in the first sacrificial layers of the layer stack (110):
is performed before said act of removing the at least one second sacrificial layer of the second sub-stack (130); and
is performed using a first selective etch being selective to material of the channel layers and material of the liner layers but not to the first and second sacrificial semiconductor material.

10. The method according to any one of the preceding claims, wherein said act of removing the at least one second sacrificial layer of the second sub-stack (130; 230) is performed using a second selective etch being selective to material of the channel layers, material of the liner layers, and the first sacrificial semiconductor material but not to the second sacrificial semiconductor material

11. The method according to any one of the preceding claims, wherein a thickness of the liner layers (133; 233) is in a range of 1 nm to 5 nm.

12. The method according to any one of the preceding claims, wherein forming the recesses (160, 260) comprises isotropic selective etching of the end surfaces of the first sacrificial layers from opposite ends of the layer stack (110; 210).

13. The method according to any one of the preceding claims, the method further comprising:
forming a sacrificial gate structure (150; 250) extending across the layer stack (110; 210), the sacrificial gate structure (150; 250) comprising a sacrificial gate body (152; 252) and a first spacer (154; 254) on opposite sides of the sacrificial gate body (152; 252);
wherein the source/drain recesses are formed by
etching through the device layer stack (110; 210) while using the sacrificial gate structure (150; 250) as an etch mask such that portions of the first, second and third sub-stacks of the layer stack (110; 210) are preserved underneath the sacrificial gate structure (150; 250).

14. The method according to any one of the preceding claims, further comprising:
forming source and drain regions (164, 166) by epitaxially growing semiconductor material on channel layer end surfaces exposed in the source/drain recesses.

## Patentansprüche

1. Verfahren zum Bilden einer Halbleiterstruktur (100), die einen Stapel von Feldeffekttransistoren, FETs, umfasst, wobei das Verfahren umfasst:
Bilden eines Schichtstapels (110; 210) auf einem Substrat (102; 202), wobei der Schichtstapel (110; 210) umfasst:
einen ersten Teilstapel (120; 220), der eine erste Opferschicht (122a; 222a) und auf der ersten Opferschicht (122a; 222a) eine Kanalschicht (124; 224), die eine oberste Schicht des ersten Teilstapels (120; 220) definiert, umfasst,
einen zweiten Teilstapel (130; 230) auf dem ersten Teilstapel (120; 220), und der eine Vielzahl von Opferschichten, die zwischen den ersten und zweiten Opferschichten (132a; 232a; 132b) abwechseln, umfasst, wobei benachbarte erste und zweite Opferschichten (132a; 232a; 132b) des zweiten Teilstapels (130; 230) durch eine Einlageschicht (133; 233) getrennt sind, wobei die ersten Opferschichten (132a; 232a) eine jeweilige unterste und oberste Schicht des zweiten Teilstapels (130; 230) definieren, wobei der zweite Teilstapel mindestens eine zweite Opferschicht (132b) umfasst;
einen dritten Teilstapel (140; 240) auf dem zweiten Teilstapel (130; 230), und der eine Kanalschicht (144; 244) umfasst, die eine unterste Schicht des dritten Teilstapels (140; 240) und eine erste Opferschicht (142a; 242a) auf der Kanalschicht (144; 244) definiert;
wobei die ersten Opferschichten aus einem ersten Opfer-Halbleitermaterial gebildet sind, die zweiten Opferschichten aus einem zweiten Opfer-Halbleitermaterial gebildet sind, das anders als das erste Opfer-Halbleitermaterial ist, und die Einlageschichten aus einem Halbleitermaterial gebildet sind, das anders als das erste und das zweite Halbleitermaterial ist;
Bilden von Source-/Drain-Vertiefungen (103), wobei die Source-/Drain-Vertiefungen Endflächen des Schichtstapels freilegen;
Bilden von Vertiefungen (160; 260) in den ersten Opferschichten des Schichtstapels durch seitliches Zurückätzen der Endflächen der ersten Opferschichten von den gegenüberliegenden Enden des Schichtstapels aus durch selektives Ätzen;
Entfernen der mindestens einen zweiten Opferschicht des zweiten Teilstapels durch selektives Ätzen, wodurch mindestens ein Hohlraum (135; 235) gebildet wird, während die ersten Opferschichten des zweiten Teilstapels durch die Einlageschichten vor dem vertikalen Ätzen geschützt werden; und
Abscheiden eines dielektrischen Materials in dem mindestens einen Hohlraum; und
Abscheiden eines dielektrischen Materials in den Vertiefungen der ersten Opferschichten;
wobei mindestens einer der Schritte des Abscheidens eines dielektrischen Materials in den mindestens einen Hohlraum; und des Abscheidens eines dielektrischen Materials in die Vertiefungen der ersten Opferschichten durch ein erstes Verfahren zur chemischen Gasphasenabscheidung, CVD, ausgeführt wird;
**dadurch gekennzeichnet, dass** das erste CVD-Verfahren umfasst:
Reagierenlassen, als ein filmbildendes Gas, eines sauerstoffhaltigen Siliziumverbindungsgases mit einem wasserstoffhaltigen Gas in einem Zustand, in dem mindestens das nicht oxidierende wasserstoffhaltige Gas mit Plasma behandelt wird, um einen Film einer fließfähigen Silanol-Verbindung zu bilden; und
anschließend Tempern des Films der fließfähigen Silanol-Verbindung in das erste dielektrische Material,
wobei das sauerstoffhaltige Siliziumverbindungsgas SiₐO_{β}(O-CₘHₙ)_{Γ}CₓH_{y} umfasst, wobei m, n, und α Ganzzahlen von 1 oder mehr sind; und wobei β, Γ, x und y Ganzzahlen von 0 oder mehr sind; und β und Γ nicht gleichzeitig gleich null sind.

2. Verfahren nach Anspruch 1, wobei der Schritt des Abscheidens eines dielektrischen Materials in den mindestens einen Hohlraum (135; 235) durch das erste CVD-Verfahren ausgeführt wird.

3. Verfahren nach Anspruch 1 oder 2, wobei die beiden Schritte des Abscheidens eines dielektrischen Materials in dem mindestens einen Hohlraum (135; 235); und des Abscheidens eines dielektrischen Materials in den Vertiefungen (160; 260) der ersten Opferschichten durch das erste Verfahren zur Gasphasenabscheidung ausgeführt werden.

4. Verfahren nach Anspruch 3, wobei die Schritte des Abscheidens eines dielektrischen Materials in dem mindestens einen Hohlraum (135); und des Abscheidens eines dielektrischen Materials in den Vertiefungen (160) der ersten Opferschichten gleichzeitig ausgeführt werden.

5. Verfahren nach einem der vorhergehenden Ansprüche, wobei ein Material der Kanalschichten Si₁₋ₐGeₐ ist, ein Material der Einlageschichten Si_{1-b}Ge_{b} ist, das erste Opferhalbleitermaterial Si_{1-c}Ge_{c} ist, und das zweite Opferhalbleitermaterial Si_{1-d}Ge_{d} ist, wobei 0 ≤ a ≤ b < c < d.

6. Verfahren nach Anspruch 5, wobei c in einem Bereich von 0,1 bis 0,25 liegt, und d in einem Bereich von 0,35 bis 0,5 liegt.

7. Verfahren nach Anspruch 5 oder Anspruch 6, wobei b kleiner als 0,05 ist.

8. Verfahren nach einem der vorhergehenden Ansprüche, wobei das dielektrische Material, das durch das erste CVD-Verfahren abgeschieden wird, SiOC oder SiOCN umfasst.

9. Verfahren nach einem der vorhergehenden Ansprüche, wobei der Schritt des Bildens von Vertiefungen (160) in den ersten Opferschichten des Schichtstapels (110):
vor dem Schritt des Entfernens der mindestens einen zweiten Opferschicht des zweiten Teilstapels (130) ausgeführt wird; und
unter Verwendung eines ersten selektiven Ätzvorgangs, der für das Material der Kanalschichten und das Material der Einlageschichten, aber nicht für das erste und das zweite Opferhalbleitermaterial selektiv ist, ausgeführt wird.

10. Verfahren nach einem der vorhergehenden Ansprüche, wobei der Schritt des Entfernens der mindestens einen zweiten Opferschicht des zweiten Teilstapels (130; 230) unter Verwendung eines zweiten selektiven Ätzvorgangs, der für das Material der Kanalschichten, das Material der Einlageschichten und das erste Opferhalbleitermaterial, aber nicht für das zweite Opferhalbleitermaterial selektiv ist, ausgeführt wird.

11. Verfahren nach einem der vorhergehenden Ansprüche, wobei eine Dicke der Einlageschichten (133; 233) in einem Bereich von 1 nm bis 5 nm liegt.

12. Verfahren nach einem der vorhergehenden Ansprüche, wobei das Bilden der Vertiefungen (160, 260) das isotrope selektive Ätzen der Endflächen der ersten Opferschichten von gegenüberliegenden Enden des Schichtstapels (110; 210) aus umfasst.

13. Verfahren nach einem der vorhergehenden Ansprüche, wobei das Verfahren ferner umfasst:
Bilden einer Opfer-Gate-Struktur (150; 250), die sich quer über den Schichtstapel (110; 210) erstreckt, wobei die Opfer-Gate-Struktur (150; 250) einen Opfer-Gate-Körper (152; 252) und einen ersten Abstandshalter (154; 254) auf gegenüberliegenden Seiten des Opfer-Gate-Körpers (152; 252) umfasst;
wobei die Source-/Drain-Vertiefungen gebildet werden durch
Ätzen durch den Bauteilschichtstapel (110; 210) hindurch, während die Opfer-Gate-Struktur (150; 250) als Ätzmaske verwendet wird, so dass Abschnitte der ersten, zweiten und dritten Teilstapel des Schichtstapels (110; 210) unterhalb der Opfer-Gate-Struktur (150; 250) erhalten bleiben.

14. Verfahren nach einem der vorhergehenden Ansprüche, ferner umfassend:
Bilden von Source- und Drain-Regionen (164, 166) durch epitaktisches Wachsenlassen eines Halbleitermaterials auf Kanalschichtendflächen, die in den Source-/Drain-Vertiefungen freigelegt sind.

## Revendications

1. Procédé de formation d'une structure semi-conductrice (100) comprenant une pile de transistors à effet de champ, FETs, le procédé comprenant :
la formation d'une pile de couches (110 ; 210) sur un substrat (102 ; 202), la pile de couches (110 ; 210) comprenant :
une première sous-pile (120 ; 220) comprenant une première couche sacrificielle (122a ; 222a) et, sur la première couche sacrificielle (122a ; 222a), une couche de canal (124 ; 224) définissant une couche supérieure de la première sous-pile (120 ; 220),
une deuxième sous-pile (130 ; 230) sur la première sous-pile (120 ; 220) et comprenant une pluralité de couches sacrificielles alternant entre des premières et des deuxièmes couches sacrificielles (132a ; 232a ; 132b), dans lequel des premières et deuxièmes couches sacrificielles (132a ; 232a ; 132b) voisines de la deuxième sous-pile (130 ; 230) sont séparées par une couche de revêtement (133 ; 233), dans lequel des premières couches sacrificielles (132a ; 232a) définissent respectivement une couche la plus basse et une couche la plus haute de la deuxième sous-pile (130 ; 230), la deuxième sous-pile comprenant au moins une deuxième couche sacrificielle (132b) ;
un troisième sous-pile (140 ; 240) sur la deuxième sous-pile (130 ; 230) et comprenant une couche de canal (144 ; 244) définissant une couche la plus basse de la troisième sous-pile (140 ; 240) et une première couche sacrificielle (142a ; 242a) sur la couche de canal (144 ; 244) ;
dans lequel les premières couches sacrificielles sont formées d'un premier matériau semi-conducteur sacrificiel, les deuxièmes couches sacrificielles sont formées d'un deuxième matériau semi-conducteur sacrificiel différent du premier matériau semi-conducteur sacrificiel et les couches de revêtement sont formées d'un matériau semi-conducteur différent des premier et deuxième matériaux semiconducteurs ;
la formation d'évidements de source/drain (103), les évidements de source/drain exposant des surfaces d'extrémité de la pile de couches ;
la formation d'évidements (160 ; 260) dans les premières couches sacrificielles de la pile de couches en décapant latéralement par attaque chimique des surfaces d'extrémité des premières couches sacrificielles depuis des extrémités opposées de la pile de couches par attaque chimique sélective ;
le retrait d'au moins une deuxième couche sacrificielle de la deuxième sous-pile par attaque chimique sélective, en formant ainsi au moins une cavité (135 ; 235), tandis que les premières couches sacrificielles de la deuxième sous-pile sont protégées contre l'attaque chimique verticale par les couches de revêtement ; et
le dépôt d'un matériau diélectrique dans au moins une cavité ; et
le dépôt d'un matériau diélectrique dans les évidements des premières couches sacrificielles ;
dans lequel au moins une desdites actions de dépôt de matériau diélectrique dans au moins une cavité et de dépôt de matériau diélectrique dans les évidements des premières couches sacrificielles est effectuée par un premier procédé de dépôt chimique en phase vapeur, procédé CVD, **caractérisé en ce que**
le premier procédé CVD comprend :
la réaction, en tant que gaz filmogène, d'un gaz composé de silicium contenant de l'oxygène avec un gaz non oxydant contenant de l'hydrogène, dans lequel au moins le gaz non oxydant contenant de l'hydrogène est transformé en plasma, pour former un film d'un composé silanol fluide ; et
ensuite, le recuit du film de composé silanol fluide pour le transformer en le premier matériau diélectrique,
dans lequel le gaz composé de silicium contenant de l'oxygène comprend SiₐO_{β}(O-CₘHₙ)_{Γ}CₓH_{y}, dans lequel m, n et α sont des nombres entiers égaux ou supérieurs à 1 ; et dans lequel b, Γ, x et y sont des nombres entiers égaux ou supérieurs à 0 ; et β et Γ ne sont pas égaux à 0 en même temps.

2. Procédé selon la revendication 1, dans lequel ladite action de dépôt de matériau diélectrique dans au moins une cavité (135 ; 235) est effectuée par le premier procédé CVD.

3. Procédé selon la revendication 1 ou 2, dans lequel les deux actions de dépôt de matériau diélectrique dans au moins une cavité (135 ; 235) et de dépôt de matériau diélectrique dans les évidements (160 ; 260) des premières couches sacrificielles sont effectuées par le premier procédé de dépôt chimique en phase vapeur.

4. Procédé selon la revendication 3, dans lequel les actions de dépôt de matériau diélectrique dans au moins une cavité (135) et de dépôt de matériau diélectrique dans les évidements (160) des premières couches sacrificielles sont effectuées simultanément.

5. Procédé selon une quelconque des revendications précédentes, dans lequel un matériau des couches de canal est Si₁₋ₐGeₐ, un matériau des couches de revêtement est Si_{1-b}Ge_{b}, le premier matériau semi-conducteur sacrificiel est Si_{1-c}Ge_{c} et le deuxième matériau semi-conducteur sacrificiel est Si_{1-d}Ge_{d}, dans lequel 0 ≤ a ≤ b < c < d.

6. Procédé selon la revendication 5, dans lequel c est compris dans une plage de 0,1 à 0,25 et d est compris dans une plage de 0,35 à 0,5.

7. Procédé selon la revendication 5 ou la revendication 6, dans lequel est b est inférieur à 0,05.

8. Procédé selon une quelconque des revendications précédentes, dans lequel le matériau diélectrique déposé par le premier procédé CVD comprend du SiOC ou du SiOCN.

9. Procédé selon une quelconque des revendications précédentes, dans lequel ladite étape de formation d'évidements (160) dans les premières couches sacrificielles de la pile de couches (110) est effectuée avant ladite étape de retrait d'au moins une deuxième couche sacrificielle de la deuxième sous-pile (130) ; et
est effectuée en utilisant une première attaque chimique sélective vis-à-vis du matériau des couches de canal et du matériau des couches de revêtement, mais pas vis-à-vis du premier et du deuxième matériau semi-conducteur sacrificiel.

10. Procédé selon une quelconque des revendications précédentes, dans lequel ladite action de retrait d'au moins une deuxième couche sacrificielle de la deuxième sous-pile (130 ; 230) est effectuée en utilisant une deuxième attaque chimique sélective vis-à-vis du matériau des couches de canal, du matériau des couches de revêtement et du premier matériau semi-conducteur sacrificiel mais pas vis-à-vis du deuxième matériau semi-conducteur sacrificiel.

11. Procédé selon une quelconque des revendications précédentes, dans lequel une épaisseur des couches de revêtement (133 ; 233) est comprise dans une plage de 1 nm à 5 nm.

12. Procédé selon une quelconque des revendications précédentes, dans lequel la formation des évidements (160, 260) comprend une attaque chimique sélective isotrope des surfaces d'extrémité des premières couches sacrificielles depuis des extrémités opposées de la pile de couches (110 ; 210).

13. Procédé selon une quelconque des revendications précédentes, le procédé comprenant en outre :
la formation d'une structure de grille sacrificielle (150 ; 250) s'étendant à travers la pile de couches (110 ; 210), la structure de grille sacrificielle (150 ; 250) comprenant un corps de grille sacrificiel (152 ; 252) et un premier espaceur (154 ; 254) sur des côtés opposés du corps de grille sacrificiel (152 ; 252) ;
dans lequel les évidements de source/drain sont formés par
attaque chimique à travers la pile de couches du dispositif (110 ; 210) tout en utilisant la structure de grille sacrificielle (150 ; 250) comme un masque d'attaque chimique, de telle sorte que des parties des première, deuxième et troisième sous-piles de la pile de couches (110 ; 210) soient préservées sous la structure de grille sacrificielle (150 ; 250).

14. Procédé selon une quelconque des revendications précédentes, comprenant en outre :
la formation de régions de source et de drain (164, 166) par croissance épitaxiale d'un matériau semi-conducteur sur les surfaces d'extrémité de couche de canal exposées dans les évidements de source/drain.
